(19) Europäisches Patentamt
European Patent Office
Office européen des brevets

(11) **EP 1 154 531 A2**

(12) **EUROPEAN PATENT APPLICATION**

(43) Date of publication:
**14.11.2001 Bulletin 2001/46**

(51) Int Cl.[7]: **H01S 5/026**, G02B 6/42

(21) Application number: **01302875.8**

(22) Date of filing: **28.03.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **28.04.2000 US 561148**

(71) Applicant: **Agere Systems Optoelectronics Guardian Corporation Orlando, Florida 32819-8698 (US)**

(72) Inventors:
• **Alam, Muhammad Ashraful Scotch Plains, New Jersey 07076 (US)**
• **Eng, julie Pennsylvania 18051 (US)**

• **Hybertsen, Mark S. West Orange, New Jersey 07052 (US)**
• **Johnson, John Evan New Providence, New Jersey 07974 (US)**
• **Ketelsen, Leonard Jan-Peter Clinton, New Jersey 08809 (US)**
• **People, Roosevelt deceased (US)**
• **Romero, Dennis Mark Macungie, Pennsylvania 18062 (US)**

(74) Representative: **Perkins, Sarah Stevens, Hewlett & Perkins Halton House 20/23 Holborn London EC1N 2JD (GB)**

(54) **Semiconductor optical devices**

(57) The invention is a semiconductor optical device and a method of manufacture. The device (10) includes a first waveguide (15) having an edge (31), and a second waveguide (12) adjacent to at least a portion of the first waveguide including the edge so that light is coupled from the first to the second waveguide. The second waveguide has a modal index which is essentially constant at least at the edge of the first waveguide. The method includes forming at least the second waveguide by Selective Area Growth (SAG) using oxide pads (61, 62) of a particular geometry to achieve the essentially constant modal index. In one embodiment, the device is an expanded beam laser with an expander portion (10b) which is less than 300 microns.

FIG. 1

EP 1 154 531 A2

## Description

### Field of the Invention

This invention relates to semiconductor optical devices, for example, expanded beam lasers, employing transfer of light between waveguides.

### Background of the Invention

In high performance optical systems, such as used in telecommunications, there is often a mismatch between the mode size of laser emission and commercially available, single mode, silica optical fiber. One approach to solving this problem is the use of an expanded beam laser, which integrates a beam expanding waveguide with the device such that light generated in the active region (which is also a waveguide) is transferred to the expanding waveguide where the diameter of the beam is increased. Such an approach is generally less expensive, and ,therefore, preferable to, the use of multi-lens systems designed to increase coupling between the laser and fiber.

One drawback in the expanded beam laser, as well as other devices where light is transferred between waveguides, is loss occurring at the region of transfer of light . As a result, workers in the art have generally concluded that the beam expander portion of the device should be at least 300 microns in length to couple the emission into the fiber without significant radiation loss. (See, Itaya, "Spot-Size Converter Integrated Laser Diodes...", IEEE Journal of Selected Topics in Quantum Mechanics, Vol. 3, pp968-974 (June 1997)). The laser portion is also usually about 300 microns in length.

It is desirable to produce a semiconductor optical device with reduced mode transfer loss between waveguides. It is also desirable to produce an expanded beam laser with as small a chip size as possible in order to reduce the cost of the device while obtaining desired device performance.

### Summary of the Invention

The invention, in one aspect, is a semiconductor optical device including a first waveguide having an edge, and a second waveguide adjacent to at least a portion of the first waveguide including the edge so that light is coupled from the first to the second waveguide, wherein the second waveguide has a modal index which is essentially constant at least at the edge of the first waveguide.

In a second aspect, the invention is a method of fabricating a semiconductor optical device comprising forming a first waveguide by epitaxial growth using oxide pads on a semiconductor substrate, and forming a second waveguide having an edge, such that the first waveguide has a modal index which is essentially constant over an area which is adjacent to the edge of the second waveguide.

### Brief Description of the Figures

These and other features of the invention are delineated in detail as examples only in the following description. In the drawing:

Figs 1 and 2 are side and top views, respectively, of a typical expanded beam laser incorporating the invention in accordance with one embodiment;

Fig 3 is an enlarged side view of a portion of the device of figs 1 and 2 illustrating a feature of the invention in accordance with a preferred embodiment;

Fig 4 is a graph showing loss characteristics of a typical expanded beam laser incorporating the invention in accordance with the same embodiment;

Fig 5 is a graph of slope efficiency as a function of length of the expander portion of an expanded beam laser in accordance with the invention;

Fig 6 is a plan view of a portion of a wafer during a certain stage of fabrification in accordance with an embodiment of a method aspect of the invention;

Fig 7 is a side view of an expanded beam laser in accordance with an alternative embodiment of the invention;

Fig. 8 is a graph of optical overlap between waveguides as a function of thickness of an underlying waveguide in accordance with an embodiment of the invention;

Fig. 9 is a graph of threshold current as a function of optical overlap in accordance with the same embodiment; and

Fig. 10 is a graph of slope efficiency as a function of optical overlap in accordance with the same embodiment.

It will be appreciated that, for purposes of illustration, these figures are not necessarily drawn to scale.

### Detailed Description

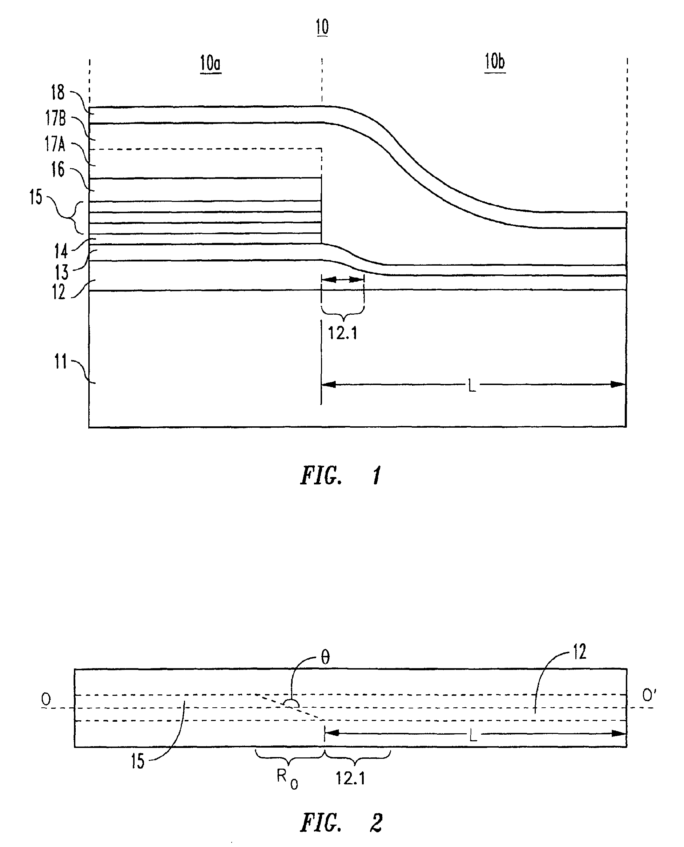

Figs 1 and 2 illustrate a typical expanded beam laser, 10, incorporating one embodiment of the invention. The device comprises an active portion, 10a, and an expander portion, 10b. The device was built upon a wafer, 11, which in this example was InP. It will be appreciated that typically several devices are built on a wafer, but for purposes of illustration only a single device is shown. A waveguide, 12, was formed on a major surface of the wafer, 11. This waveguide is typically a semiconductor, which in this example comprises InGaAsP. The waveguide, 12, was preferably epitaxially formed by metallorganic chemical vapor deposition (MOCVD) using oxide pads as described below in order to produce selective area growth (also known in the art as SAG.) It will be noted that a vertically tapered region, 12.1, was formed in the waveguide.

A spacer layer, 13, was formed on the waveguide layer, 12. In this example, the spacer layer, 13, was preferably InP deposited by MOCVD to a thickness of approx. 300 angstroms. This layer can be formed during the SAG growth, or subsequently as the first layer of the SCH and active layer growth (to be described), or partly during SAG growth and partly during SCH and active growth. It will be noted that layer 13 conforms to the waveguide, 12, and extends from the active portion, 10a, of the device to the expander portion, 10b, of the device. Preferably formed by MOCVD over essentially the entire surface of the spacer layer, 13, were successive layers of semiconductor material, 14-16. In this particular example, layer 14 was a separate confinement heterostructure (SCH) comprising n-type InGaAsP. Preferably a plurality of quantum well layers, 15, were formed over the SCH, and in this example comprised alternate layers of compositionally different layers of InGaAsP. The layers, 15, made up the active layer of the active device portion, 10a, and also functioned as a waveguide for light generated therein.. An additional confinement layer, 16, comprising p-type InGaAsP was preferably formed over the active layer. A partial p-type InP cladding layer, 17A, was grown over layer 16.

A mask (not shown) was then formed over the portion of the layer 17A which was to comprise the active portion, 10a, thereby exposing what was to become the expander portion, 10b, of the device. The exposed portions of the layers, 14-17A were then etched by standard techniques, e.g. a wet chemical etch employing a combination of $H_2SO_4$, $H_2O$, and $H_2O_2$. As illustrated in the top view of Fig 2, the layers 14-17A are etched at an oblique angle, $\theta$, to the propagation axis, O-O$^1$ of the light emission. This is also known in the art as a lateral taper etch, thereby forming a lateral taper region, 20, which allows the expanded beam device to couple light from the active layer, 15, into the waveguide, 12. The length, L, of the expander portion, 10b is measured from the end of the tapered etch region to the end of the device. The epitaxial layers, 12-17A, were then etched to form a mesa configuration in accordance with standard practice. The resulting structure was then preferably covered with a layer, 17B, which is typically InP, and a layer, 18, which is typically InGaAs. These layers were also preferably formed by MOCVD.

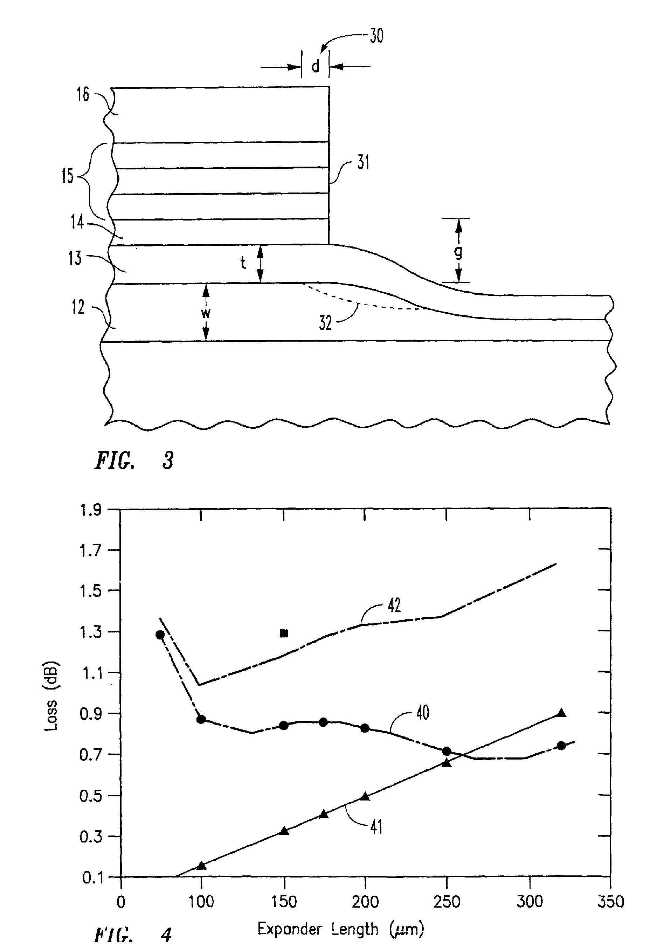

Fig 3 is an enlargement of a portion of the device of Fig 1 illustrating a preferred feature of the invention. It will be noted that active layer, 15, (as well as layers 14 and 16) has an end portion, 30, which extends from the edge, 31, of the layer to a distance, d, of preferably at least 20 microns. The profile of the waveguide, 12, is illustrated by a solid line. It will be noted that the waveguide, 12, is optically flat beneath the end portion, 30, of the active region (waveguide), 15. This means that the modal index of the waveguide, 12, is essentially constant, i.e. preferably varies no more than 5 percent, under the end portion. (The modal index is a known function of the index of refraction and thickness, w, of the waveguide, 12, as well as of the spacing, g, between the waveguide, 12, and the active region, 15. (See, e. g., Diode Lasers and Photonic Integrated Circuits by Couldren & Corzine (Wiley Series In Microwave And Optical Engineering (1995) pp. 322-325 and pp. 428-437.)). This is to be contrasted with the profile of a typical prior art waveguide which is illustrated by broken line, 32, where considerable undercutting of waveguide 12 is present under the end portion, 30.

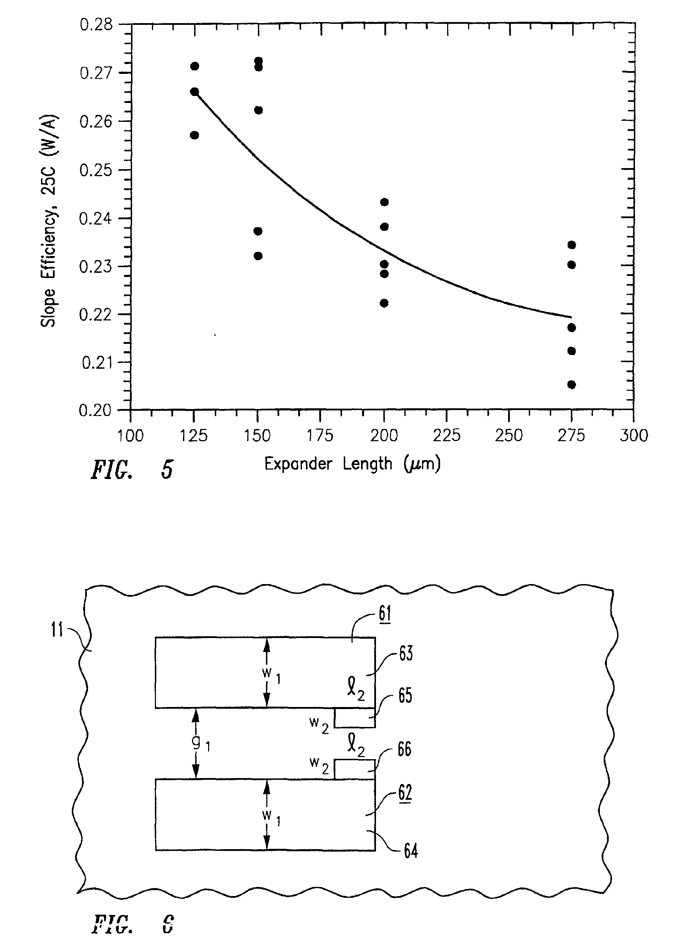

It has been determined by Applicants that control of the modal index of waveguide 12 under the end portion, 30, of the active layer, 15, in such a manner results in considerable reduction in mode transfer losses between the active region and the waveguide, which in turn permits reduction in the length, L, of the expander portion of the device. For example, Fig 4 shows calculated mode transfer loss as a function of expander length in curve 40 for a device with increasing expander length (10b). It will be noted that mode transfer loss is fairly low and does not increase significantly until the expander portion is 100 microns or less. Also, it is known that the free carrier absorption loss in the expander portion, illustrated by curve, 41, decreases essentially linearly as expander length decreases so that overall loss, illustrated by curve 42, decreases as the expander length decreases until expander length is 100 microns or less. Thus, short expander lengths, which are economical to make, are possible with use of the inventive principles. In fact, device performance should improve with shorter expander lengths if mode transfer loss (curve 40) is controlled in accordance with the invention.

Further, Fig 5 illustrates experimental measurements of slope efficiency (light output as a function of current input) as a function of the expander length for devices fabricated according to the invention. It will be noted that high power devices are possible for short expander length devices.

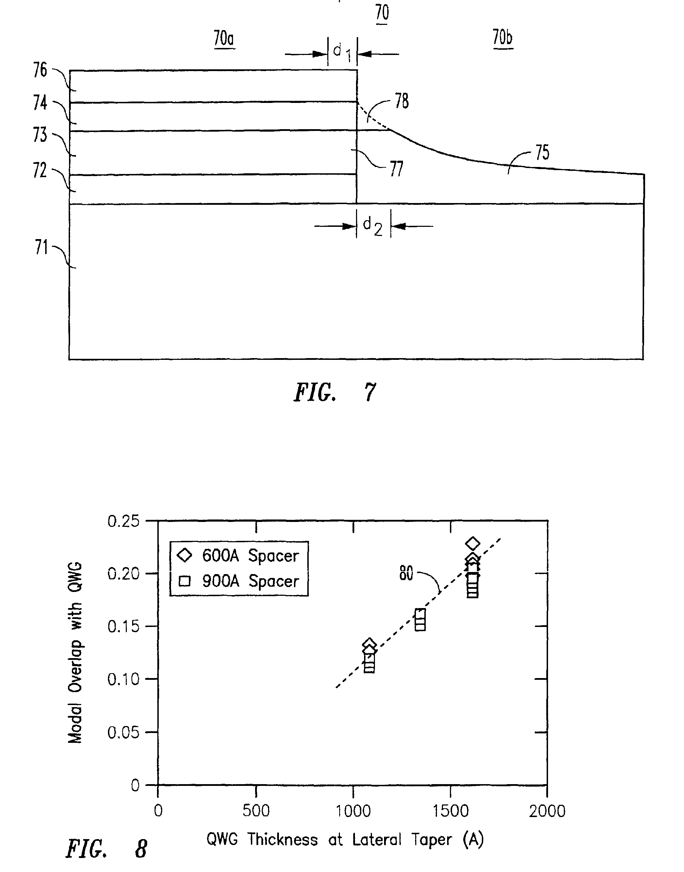

Fabrication of the waveguide, 12, having the desired modal index was accomplished by Selective Area Growth (SAG) techniques described in detail in Alam 1-1-9, EPO 99304468.4, filed 6/8/99, assigned to Lucent Technologies. Basically, as illustrated in Fig 6, the method involves the deposition of silicon dioxide pads, 61 and 62, on the surface of the substrate 11. Each pad included a primary rectangular portion, 63 and 64, respectively, having a width, $w_1$ so as to create a gap width, $g_1$, between the pads. In order to vary the profile of the waveguide at what will become the end portion of the laser (30 of Fig 3), additional rectangular pieces, 65 and 66, of silicon dioxide, hereinafter referred to as "hammers", were deposited at the ends of the rectangular portions, 63 and 64. Each hammer had a length, $l_2$ and a width, $w_2$. Growth of an MOCVD waveguide layer using these pads was modeled using the three dimensional modeling technique described in the cited application, and the growth profile was compared with the desired profile of the waveguide. The dimensions of the pads were modified until the modeled profile corresponded to the desired profile shown in Fig 3.

The following examples all provided useful waveguide profiles according to the invention. All waveguides were grown by MOCVD using silicon dioxide pads with a gap, $g_1$, of approx. 40 microns, a hammer length, $l_2$, of 80 microns and a hammer width, $w_2$, of 10 microns. A 270 micron beam expander length, L, was formed with a pad width $w_1$, of 80 microns. A 200 micron beam expander length, L, was made with a pad width, $w_1$, of 90 microns. A device with a 150 micron beam expander length, L, was made using a pad width, $w_1$, of 100 microns. A device with a 125 micron beam expander length, L, was made using a pad width, $w_1$, of 120 microns. Finally, it is expected that a 100 micron expander length device could be fabricated with a pad having a width, $w_1$, of 180 microns and a hammer width, $w_2$ of 10 microns. Of course, it will be realized that these values are merely illustrative, and such parameters can be varied according to particular needs.

The waveguide layer, 12, as well as the other semiconductor layers, 13-18, were all epitaxially grown by standard MOCVD techniques. For example, the layers were grown at a temperature of 600 deg. C with a growth rate of 1 micron per hour.

In addition to controlling modal index as described above, it is also preferable to maximize as much as possible the overlap of the optical beam from waveguide, 15, with the underlying waveguide, 12, at the lateral taper region, 20. The "modal overlap" is defined herein as the fraction of the mode intensity which is contained in the underlying waveguide, 12, at the lateral taper region, 20. Fig. 8 is an illustration of modal overlap as a function of the thickness, w, of the underlying waveguide, 12, at the lateral taper region for a spacer layer, 13, having a thickness of 600 angstroms (indicated by "◇") and 900 angstroms (indicated by "□"). Thus, the curve, 80, illustrates the primary dependance of modal overlap on the thicknesses of the waveguide, 12, and spacer layer, 13.

In general, the modal overlap (MO) is given by:

$$MO = \frac{\int \emptyset^2(y)\,dy}{\int \emptyset^2(y)\,dy}$$

where $\emptyset$ is the optical field, y is the vertical direction, the numerator is integrated over the waveguide, 12, at the taper region and the denominator is integrated over the entire device at the taper region.

In one particular example, layers 14 and 16 were 500 angstroms thick 1.08μm InGaAsP, and layer, 15, had 9 quantum wells of 70 angstroms thick 1.3μm InGaAsP and 8 barrier layers of 100 angstroms thick 1.08μm InGaAsP. In that case, it was found that the desired MO was given by:

$$MO = -0.012 + (0.000149)\,(w)$$

$$-(0.0000520)\,(t)$$

where t is the thickness of the spacer layer at the lateral taper region, 20.

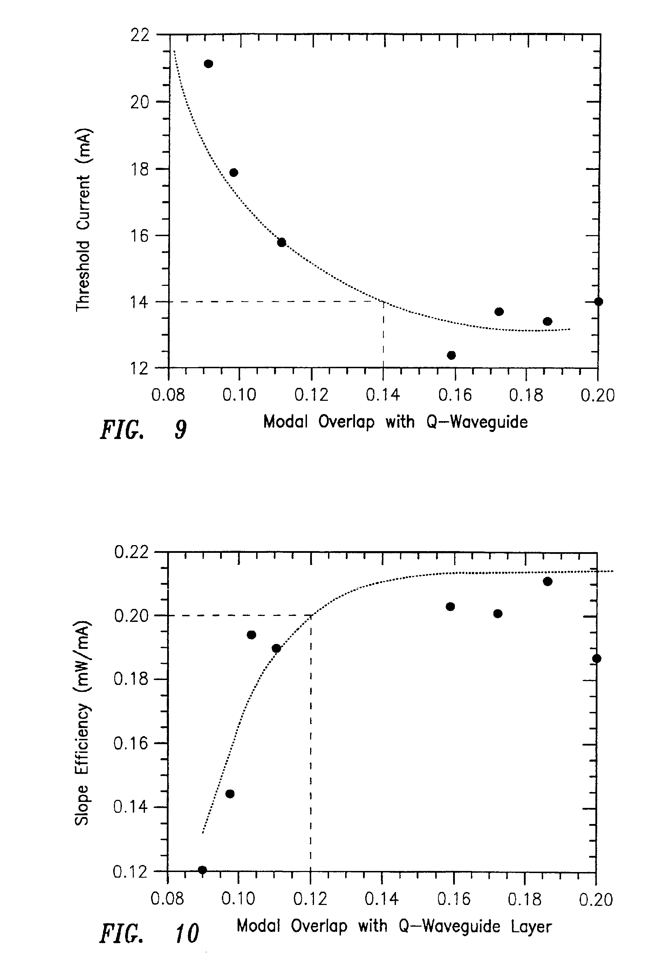

Finally, Figs. 9 and 10 illustrate, respectively, experimental threshold current and slope efficiency as a function of calculated modal overlap. Most communications - grade lasers have a threshold current of 14 milliamps or less, and a slope efficiency of 0.2 mW/mA or greater. For these types of lasers, therefore, a modal overlap of .14 or greater is preferred.

Fig 7. illustrates another embodiment of the invention. The figure shows an expanded beam laser, 70, with a laser portion, 70a , and an expander portion, 70b. The active portion, 70a includes two semiconductor cladding layers, 72 and 74, with an active layer, 73, therebetween, the layers being epitaxially grown over a semiconductor substrate, 71. A semiconductor contact layer, 76, is also grown over the cladding layer, 74. The semiconductor active layer, 73, (as well as the layers 72, 74, and 76) includes an end portion, $d_1$, which extends from an edge, 77, to a distance of approx. 20 microns into the layer. The expander portion, 70b, includes a waveguide layer, 75, epitaxially grown over the substrate, 71, using selective area growth techniques previously discussed.

It will be appreciated that the primary difference of this embodiment over the previous embodiment is that the waveguide layer, 75, is formed adjacent to, rather than underneath, the active layer, 73. However similar considerations apply to the profile of the waveguide layer. In particular, the broken line, 78, indicates a typical profile in prior art devices. (See, Itaya, "Spot-Size Converter Integrated Laser Diodes...", cited previously.) However, applicants have discovered that losses can be significantly reduced by making the waveguide layer, 75, optically flat, as indicated by the solid line, in the area adjacent to the edge, 77, of the active layer, 73, and extending a distance, $d_2$, from the edge. Preferably, the distance $d_2$ lies within the range 20 to 50 microns.

In the context of the present application, the term "adjacent" is intended to mean "in close proximity" or "nearby", and is not intended to exclude the possibility of layers (such as 13 and 14 of Fig 2 and 3) between the waveguides.

**Claims**

1. A semiconductor optical device including a first waveguide (15) having an edge (31), and a second waveguide (12) adjacent to at least a portion of the first waveguide including the edge so that light is coupled from the first to the second waveguide, wherein the second waveguide has a modal index which is essentially constant at least at the edge of the first waveguide.

2. The device according to claim 1 wherein the first waveguide comprises an active region of a semiconductor laser.

3. The device according to claim 2 wherein the device is an expanded beam laser.

4. The device according to claim 1 wherein the second waveguide has a modal index which is essentially constant beneath an end portion of the first waveguide extending from the edge of the first waveguide.

5. The device according to claim 1 wherein the second waveguide is contiguous with the edge of the first waveguide and has a modal index which is essentially constant from said edge over a portion along a direction of light propagation in the second waveguide.

6. The device according to claim 3 wherein the expanded beam laser has an expander portion which is less than 300 microns.

7. The device according to claim 1 wherein the modal index of the second waveguide is essentially constant over a distance of at least 20 microns from the edge of the first waveguide.

8. The device according to claim 1 wherein loss due to transfer of light from the first to the second waveguide is no greater than 1 dB.

9. The device according to claim 1 wherein the device has a modal overlap (MO) given by:

MO = -0.0012 + (9.000149) w - (0.0000520) t

where w is the thickness of the second waveguide and t is the thickness of a spacer layer between the waveguides.

10. An expanded beam laser device comprising an active region (10a) and an expander portion (10b), wherein the expander portion is less than 300 microns.

11. A method of fabricating a semiconductor optical device comprising:

forming a first waveguide (12) by epitaxial growth using oxide pads (61, 62) on a semiconductor substrate; and

forming a second waveguide (15) having an edge (31), such that the first waveguide has a modal index which is essentially constant over an area which is adjacent to the edge of the second waveguide.

12. The method according to claim 11 wherein the waveguides are formed by MOCVD.

13. The method according to claim 11 wherein the oxide pads each comprise a primary rectangular portion (63, 64) and includes additional smaller rectangular pieces (65, 66) formed in a gap between the primary rectangular portions at one end of the primary portions.

14. The method according to claim 13 wherein the width of the primary portions is within the range 80- 180 microns.

FIG. 1

FIG. 2

FIG. 3

FIG. 4

*FIG. 5*

*FIG. 6*

**FIG. 7**

**FIG. 8**

FIG. 9

FIG. 10